Europäisches Patentamt

European Patent Office

Office européen des brevets

(11) Veröffentlichungsnummer: **0 074 030**
A2

(12) **EUROPÄISCHE PATENTANMELDUNG**

(21) Anmeldenummer: 82107878.9

(22) Anmeldetag: 27.08.82

(51) Int. Cl.³: **H 01 L 39/18**
//H03K17/92

(30) Priorität: 05.09.81 DE 3135177

(43) Veröffentlichungstag der Anmeldung:
16.03.83 Patentblatt 83/11

(84) Benannte Vertragsstaaten:
CH FR GB IT LI NL

(71) Anmelder: BROWN, BOVERI & CIE Aktiengesellschaft
Kallstadter Strasse 1
D-6800 Mannheim 31(DE)

(72) Erfinder: Dustmann, Cord-Henrich, Dr. Dipl.-Chem.
Diemstrasse 10
D-6490 Weinheim(DE)

(74) Vertreter: Kempe, Wolfgang, Dr. et al,
c/o Brown, Boveri & Cie AG Postfach 351
D-6800 Mannheim 1(DE)

(54) Supraleitender Schalter.

(57) Ein supraleitender Schalter (1), dessen elektrischer Widerstand durch gesteuertes Überschreiten wenigstens eines der kritischen Werte der Temperatur, des Magnetfeldes und der Strombelastung von Null in einem hohem, den Schaltkreis, in dem der supraleitende Schalter (1) angeordnet ist, angepaßten Wert übergeführt wird, besteht aus Faserleitern aus mit einer supraleitenden Schicht versehenen Fasern. Die Faserleiter sind mit einer wärmeableitenden Matrix umgeben, deren Schichtdicke sowohl den erwünschten Normalleitungswiderstand für den Schalter (1) als auch eine ausreichende Stabilisierung in der Supraleitungsphase gewährleistet. Der supraleitende Schalter (1) kann mit einer supraleitenden Spule (2) elektrisch verbunden sein, wobei die Wicklungen der Spule (2) ebenfalls Faserleiter enthalten und mit den Faserleitern des Schalters (1) einen durchgehenden Faserleiterstrang bilden.

B R O W N , B O V E R I & C I E     AKTIENGESELLSCHAFT
Mannheim                                  31. Aug. 1981
Mp.-Nr. 613/81                          ZPT/P2-La/Br

## Supraleitender Schalter

Die Erfindung bezieht sich auf einen supraleitenden Schalter
nach dem Oberbegriff des Patentanspruches 1.

Das Hauptkennzeichen eines Supraleiters, der völlige Verlust
des elektrischen Widerstandes unterhalb einer kritischen
Temperatur, eines kritischen Magnetfeldes und einer
kritischen Strombelastung, wird bei supraleitenden Schaltern
ausgenutzt, indem wenigstens einer dieser kritischen Werte
von außen beeinflußt wird, sodaß ein Übergang des Supraleiters aus der Supraleitungsphase in die Normalleitungsphase
oder umgekehrt erfolgt. Hierbei ändert sich der Widerstandswert des Supraleiters sprunghaft von Null im supraleitenden
Zustand auf einen relativ hohen Wert im Normalleitungszustand.

In einem supraleitenden Stromkreis kommt diese sprunghafte
Widerstandsänderung einer Schaltfunktion gleich.
(K. Grawatsch, Grundlegende Untersuchungen über die Einsatzmöglichkeiten supraleitender Schalter in der kryogenen
Energietechnik, Kernforschungsanlage Jülich, Jül-1132-SE,
Nov. 1974).

Der Begriff "supraleitender Schalter" ist in der Literatur
nicht scharf abgegrenzt. Es wird im folgenden mit diesem
Begriff der Bereich eines supraleitenden Schaltkreises
bezeichnet, dessen elektrischer Widerstandswert durch gesteuertes Über-oder Unterschreiten der genannten kritischen
Werte beeinflußt wird. Solch ein supraleitender Schalter ist
im allgemeinen durch Zu-und Ableitungen mit übrigen Elementen
des supraleitenden Schaltkreises verbunden. Er kann jedoch
auch Bestandteil eines Elementes, z.B. einer supraleitenden
Spule sein.

Für die Herstellung von supraleitenden Schaltern werden u.a.
Drähte verwendet, die aus supraleitenden Filamenten, z.B. aus
$N_bT_i$ oder $Nb_3Sn$ bestehen. Die Filamente sind in einer Matrix
aus bsw. CuNi mit relativ hohem spezifischen elektrischen
Widerstand eingebettet.

Die Herstellung von supraleitenden Drähten für Niob-Titan-
Supraleiter ist wegen der hohen Duktilität des $N_bT_i$ relativ
problemlos. Die niedrige kritische Temperatur hat eine
geringe elektrische Stabilität der supraleitenden Drähte zur
Folge, wodurch ein supraleitendender Schalter aus $N_bT_i$ nicht
immer den gestellten Anforderungen gerecht wird. Niob-Titan-
Supraleiter haben den Nachteil, einer relativ tiefen
kritischen Temperatur von ca. 9,5K und eines ebenfalls tiefen
kritischen Magnetfeldes von ca. 12T. Supraleitende Schalter
aus diesem Material müssen den kritischen Werten Rechnung
tragen, wodurch die Einsatzmöglichkeiten stark eingeengt
sind.

Die metallurgischen Herstellungsverfahren für supraleitende
Drähte sind für Nb₃Sn-Supraleiter sehr aufwendig. Zur Bildung
des supraleitenden Materials muß eine Diffusionsglühung bei
bsw. 700°C für ca. 60 Stunden durchgeführt werden. Wird diese
Glühung vor dem Anordnen der Drähte (z.B. Wickelprozess)
durchgeführt, so besteht beim Anordnen die Gefahr der Beschädigung des sehr spröden Nb₃Sn-Materials, was sich erst an
dem fertigen Schalter überprüfen läßt. Wird die Glühung nach
dem Anordnungsprozess durchgeführt so muß der gesamte Schalter einschließlich der Isolation geglüht werden, was an die
Isolation und die verwendeten Struktur- und Kontaktierungsmaterialien besondere Anforderungen bezüglich der Temperaturbeständigkeit stellt.

Es ist Aufgabe der Erfindung, supraleitende Schalter unter
Vermeidung der Nachteile bei Verwendung von Filamentleitern
herzustellen.

Gemäß der Erfindung wird diese Aufgabe dadurch gelöst, daß
die Supraleiter des Schalters aus Faserleitern, die aus mit
einer supraleitenden Schicht versehenen Fasern bestehen,
hergestellt sind.

Es ist bekannt, Kohlenstoffasern mit einer dünnen Schicht
einer Niobverbindung der allgemeinen Formel NbCxNy und einer
äußeren hoch leitfähigen Materialschicht zu versehen. Derartige supraleitende Niobcarbonnitrid-Schichten können
kontinuierlich hergestellt werden, bsw. kann aus dampfförmigen Niobchlorid in einer Wasserstoffatmosphäre bei etwa
600°C metallisches Niob auf den Kohlenstoffasern (Kohlenstoffilamenten) abgeschieden werden. Dieses metallische Niob
wird anschließend in einer Ammoniak- und Methanatmosphäre bei

etwa $1000^{0}$C in die supraleitende Niobcarbonnitridverbindung
umgewandelt (DE-AS 28 56 885; K.Brennfleck et al, Chermical
Vapor Deposition of Superconducting Niobium Carbonitride
Films on Carbon Fibres, Seventh International Conference on
Chemical Vapor Deposition, October 14-19, 1979, Los Angeles,
Ca./USA).

Bisher sind Supraleiter aus Filamentleitern in Drahtform und
als Faserleiter bekannt. Um die Unterschiede hervorzuheben,
wird im folgenden der Begriff "Filamente" für die fest in
eine metallische Matrix eingebetteten supraleitenden Fäden
aus bsw. $Nb T_i$ oder $Nb_3 Sn$ (Filamentleiter) benutzt, und der
Begriff "Fasern" gilt für unverflochten und ungebunden
vorliegende Fäden aus jeglichem Material, z.B. C-Fasern,
Bohrfasern, Stahlfasern.

Ein supraleitender Schalter gemäß der Erfindung ist zweckmäßigerweise derart herzustellen, daß mehrere 1000 mit einer
supraleitenden Schicht versehene Fasern mit einer Matrix
einer im allgemeinen relativ hochohmigen Metallschicht
umgeben und zu einem Bündel zusammengefaßt werden, und daß
dieses Faserbündel durch eine Isolationsschicht umgeben wird.
Das isolierte Faserbündel wird zu einer vorzugsweise niederinduktiven Leiteranordnung verwunden, in Kunststoff getränkt
und in einer Form ausgehärtet. Nach dem Aushärten ist die
Verbindung so stabil, daß die Form entfernt werden kann und
ein Aufnahmekörper nicht erforderlich ist. Die jedes Bündel
umgebende Isolationsschicht kann z.B. eine Umbandelung mit
Folie oder eine Umspinnung oder Umflechtung von Glasfasern
sein.

Im Gegensatz hierzu werden bei der Herstellung von supraleitenden Spulen zur Gewährleistung einer guten Wärmeabführung und zur Stabilisierung des Supraleiters trotz Auftretens hoher Felder die Filamente mit einem gut leitenden
Material (in der Regel Kupfer) ausreichender Schichtdicke
umgeben (G. Meyer, R. Maix, Brown Boveri Mitteilungen 1970
57 (8-9) 355-362). Hierdurch kann eine ausreichende
elektrische und mechanische Stabilität des Leiters erreicht
werden und die niederohmige Matrix kann kurzzeitig den Strom
aufnehmen, sobald im Supraleitungsmaterial ein Widerstand
auftritt.

Bei supraleitenden Schaltern besteht jedoch nicht die
Forderung nach einem elektrisch gut leitenden Matrixmaterial,
das notfalls den Strom mit möglichst geringen Verlusten
kurfristig aufnehmen kann. Supraleitende Schalter sollen in
der Normalleitungsphase einen Widerstand aufweisen, der den
Stromdurchfluß bei Übergang von der supraleitenden Phase in
die Normalleitungsphase sprunghaft stark reduziert. Der
hierfür notwenige Normalleistungswiderstandswert resultiert
im wesentlichen aus dem geforderten Schaltverhalten und der
Schaltungsanordnung, in der der supraleitende Schalter
eingesetzt werden soll. Dabei ist die Grenzlast, das ist die
Strombelastbarkeit, beim Übergang von der Supraleitung zur
Normalleitung, zu beachten, um ein "Ausbrennen" des Schalters
zu vermeiden.

Die Forderungen zur Stabilisierung sind bei supraleitenden
Schaltern nicht so hoch wie bei Spulen, da die Windungen des
Schalters bsw. bipolar angeordnet werden können, so daß ein
Auftreten hoher Magnetfelder vermieden wird. Durch bipolare
Windungsanordnungen lassen sich darüber hinaus niederinduktive Schalter herstellen.

Zur Realisierung der Anforderungen kann vorzugsweise wenigstens in einem Bereich des Supraleiters des Schalters
die Schichtdicke der Matrix, mit der die supraleitenden
Fasern umgeben sind, so bemessen werden, daß der erwünschte
Normalleistungswiderstandswert für den Schalter realisiert
wird und andererseits eine ausreichendes Stabilisierung in
der Supraleitungsphase gewährleistet ist. Diese Anforderungen
können darüber hinaus in vorteilhafter Weise auch durch
Auswahl eines geeigneten Matrixmaterials erfüllt werden.

Durch die hohe mechanische Festigkeit der Faserleiter kann
die Schichtdicke der Matrix, das ist der Abstand zwischen
zwei supraleitenden Fasern, auch bei Verwendung von Kupfer
sehr klein gehalten werden, so daß sich ein realiv hoher
Normalleitungswiderstand ergibt. Zur Erzielung eines hohen
Normalleitungswiderstandes kann als Matrixmaterial jedoch
auch ein Material geringerer elektrischer Leitfähigkeit
jedoch ausreichender Wärmekapazität, um den Schalter bei
hohen Schaltleistungen gegen Ausbrennen zu sichern, verwendet
werden (z.B. CuNi).

Es ist von Vorteil die Wicklung einer supraleitenden Spule,
die mit einem erfindungsgemäßen supraleitenden Schalter in
einem Stromkreis angeordnet ist, ebenfalls aus Faserleitern,
die aus mit einer supraleitenden Schicht versehenen Fasern
bestehen, herzustellen. Dieser Vorteil tritt dann besonders
augenfällig hervor, wenn der supraleitende Schalter und die
supraleitende Spule aus einem durchgehenden Faserleitungsstrang bestehen und so der Supraleiter des Schalters mit dem
der Spule wenigstens mit jeweils einem Ende materialeinheitlich, unter Vermeidung einer Materialinhomogenität, die durch
eine aufwendig herstellbare Verbindungsstelle (G. Luderer et
al, Superconducting joint between multifilamentary wires,
Cryogenics 14 (1974) 518) gegeben sein kann, miteinander verbunden sind.

Bei einem Schaltkreis, der einen supraleitenden Schalter und eine supraleitende Spule enthält, deren Supraleiter aus Faserleitern aufgebaut sind, ist es vorteilhaft, daß die Werte der Schichtdicke der Matrix und/oder der Leitfähigkeit des Matrixmaterials im Bereich des Supraleiters des Schalters geringer sind, als die entsprechenden Werte des Supraleiters der Spule. Auf diese Weise kann sichergestellt werden, daß die Anforderungen an den Schalter bezüglich Normalleitungswiderstand und an die Spule bezüglich Stabilisierung gleichzeitig erfüllt werden. Beim Aufbringen des Matrixmaterial werden für den Bereich des Schalters und den Bereich der Spule hinsichtlich Schichtdicke und/oder Matrixmaterial unterschiedliche Verfahren verwendet.

Eine weitere vorteilhafte Ausgestaltung der Erfindung liegt darin, daß in die Nähe der Faserleiter des Schalters wenigstens ein isolierter Heizdraht angeordnet ist. Durch einen innigen Wärmekontakt zwischen Heizdraht und Faserleiter kann eine relativ kurze Zeitkonstante für die Auslösung des Schalters (Übergang in den Normalleitungszustand in Folge Erwärmung) realisiert werden.

Erfindungsgemäß kann zur magnetischen Auslösung des Schalters (Überschreiten des kritischen Magnetfeldes am Ort der Faserleiter) in der Nähe des Faserleiters des Schalters ein zusätzlicher, ein Magnetfeld erzeugender Faserleiter derart angeordnet werden, daß in dessen Magnetfeldbereich die Faserleiter des Schalters verlaufen. Durch diese Anordnung kann im allgemeinen eine geringere Auslösezeit als bei temperaturbedingter Auslösung realisiert werden.

Es kann auch eine Kombination von thermischer und magnetischer Auslösung vorteilhaft sein.

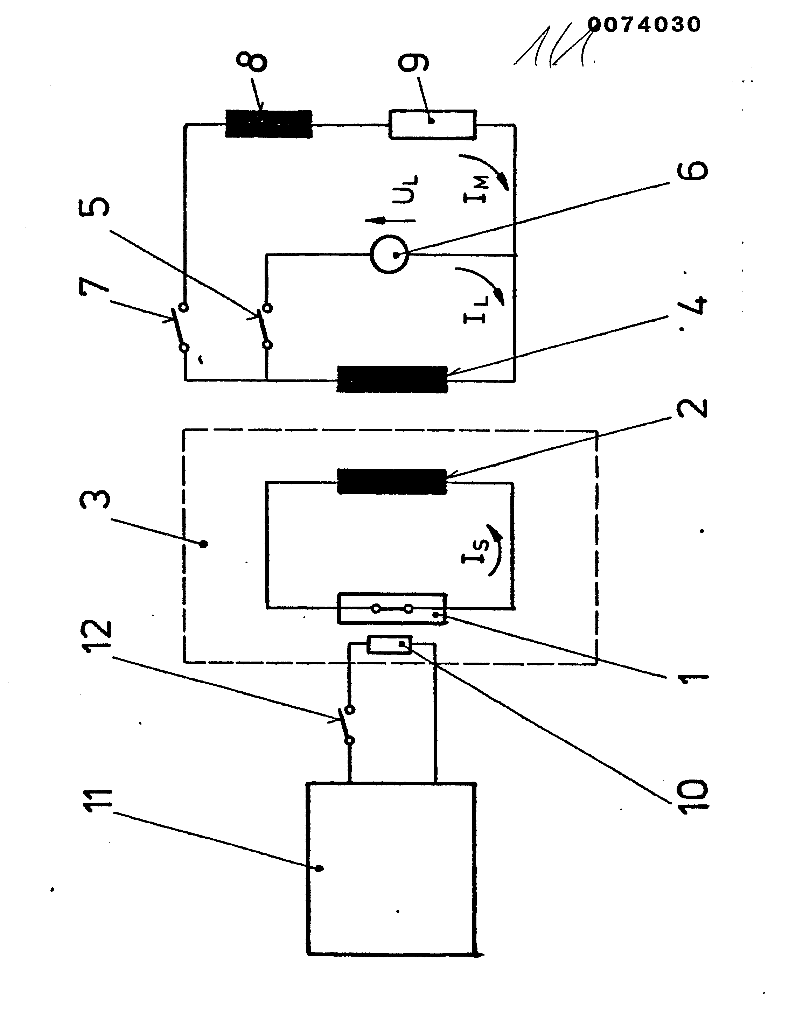

An Hand der Zeichnung wird eine Schaltungsanordnung mit einem erfindungsgemäßen supraleitenden Schalter näher erläutert.

Die einzige Figur zeigt ein Prinzipschaltbild eines induktiven supraleitenden Energiespeichers mit supraleitendem Schalter, Ladekreis und Lastkreis.

Ein Energiespeicherkreis bestehend aus einem supraleitenden Schalter 1 und einem Energiespeicher in Form einer supraleitenden Spule 2, die zu einem Kreis zusammengeschaltet sind, befindet sich in einem, durch eine gestrichelte Linie angedeuteten Kryostaten 3. Die supraleitende Spule 2 ist magnetisch mit einer Koppelspule 4 gekoppelt, diese liegt mit einem Ladekreisschalter 5 und einer Gleichstromquelle 6 in einem Ladekreis und mit einem Lastkreisschalter 7 und einer Magnetfeldspule mit induktiver Last 8 und ohmscher Last 9 in einem Lastkreis.

Auf den supraleitenden Schalter 1 wirkt ein Heizwiderstand 10 ein, der durch eine Stromversorgung 11 bei geschlossenem Heizkreisschalter 12 den supraleitenden Schalter aufheizt und von der Supraleitungsphase in die Normalleitungsphase überführt. Bei geöffnetem Heizkreisschalter 12 wird der supraleitende Schalter 1 durch den Kryostaten heruntergekühlt und in die Supraleitungsphase übergeführt.

Die Wirkungsweise der Schaltungsanordnung ist folgende:
Zum Laden des Energiespeichers wird die Koppelspule 4 zunächst durch die Gleichstromquelle 6 aufgeladen, wobei der Ladekreisschalter 5 geschlossen und der Lastkreisschalter 7 geöffnet ist. Der supraleitende Schalter 1 befindet sich
ebenfalls im offenen normalleitenden Zustand bis der Ladevorgang abgeschlossen ist. Wenn der Strom im Ladekreis konstant
gehalten wird, und die Spannung über die Koppelspule 4 nur
noch dem ohmischen Spannungsabfall entspricht, ist der
Ladevorgang abgeschlossen. Der supraleitende Schalter 1 wird
geschlossen, d.h. er wird in den supraleitenden Zustand
übergeführt, indem der Heizkreisschalter 12 geöffnet wird und
der supraleitende Schalter in Folge der Kryostattemperatur
unter die kritische Temperatur abgekühlt wird. Der Ladekreisschalter 5 wird geöffnet. Durch die Unterbrechung des
Ladestromes $I_L$ wird die Energie der Koppelspule 4 in die
supraleitende Spule 2 getrieben. Es fließt nun für praktisch
beliebige Dauer ein verlustloser Strom $I_S$ im Energiespeicherkreis. Die supraleitende Speicherspule 2 ka in eine Magnetfeldspule 8,9 entladen werden. Hierzu wird der Lastkreisschalter 7 geschlossen und der supraleitende Schalter 1 in
Folge schließens des Heizkreisschalters 12 und aufheizens des
Heizwiderstandes 10 geöffent.

Der Energiespeicherkreis, der aus supraleitenden Schalter 1
und supraleitender Spule 2 aufgebaut ist besteht aus einem
durchgehenden Faserleiterstrang, der im Bereich der Spule 2
eine magnetfelderzeugende Wicklungsanordung aufweist und im
Bereich des Schalters 1 bipolar angeordnet ist. Die Matrix in
die die einzelnen supraleitenden Fasern des Faserleiterstranges eingebettet sind, besteht im Bereich der Spule 2 zur
Gewährleistung guter Wärmeleitung und hoher Stabilität aus
Kupfer. Im Bereich des Schalters, in dem ein hoher Normalleitungswiderstand gefordert wird, besteht die Matrix aus
CuNi.

A n s p r ü c h e

1. Supraleitender Schalter (1), dessen elektrischer Widerstand durch gesteuertes Überschreiten wenigstens eines der kritischen Werte der Temperatur, des Magnetfeldes und der Strombelastung von Null in einen hohen, den Schaltkreis, in dem der supraleitende Schalter (1) angeordnet ist, angepaßten Wert übergeführt wird, dadurch gekennzeichnet, daß der supraleitende Schalter (1) aus Faserleitern aus mit einer supraleitenden Schicht versehenen Fasern besteht.

2. Supraleitender Schalter (1) nach Anspruch 1, dadurch gekennzeichnet, daß die Faserleiter mit einer wärmeableitenden Matrix umgeben sind, deren Schichtdicke (Abstand zwischen zwei Faserleitern) sowohl den erwünschten Nomalleitungswiderstandswert für den Schalter (1) als auch eine ausreichende Stabilisierung in der Supraleitungsphase gewährleistet.

3. Supraleitender Schalter (1) nach einem der Ansprüche 1 oder 2, dadurch gekennzeichnet, daß die Faserleiter mit einer wärmeableitende Matrix umgeben sind, deren Material hinsichtlich Leitfähigkeit derart ausgewählt ist, daß sowohl der erwünschte Normalleitungswiderstandswert für den Schalter (1) als auch eine ausreichende Stabilisierung in der Supraleitungsphase realisiert ist.

4. Supraleitender Schalter (1) nach einem der Ansprüche 1 bis 3, der in einem Stromkreis mit einer supraleitende Spule (2) elektrisch verbunden ist, wobei die
Wicklungen der Spule (2) ebenfalls Faserleiter enthalten, die
aus mit einer supraleitenden Schicht versehenen Fasern bestehen, dadurch gekennzeichnet, daß Schalter (1) und Spule (2) aus einem durchgehenden Faserleiterstrang bestehen,
und so wenigstens eine Verbindungsleitung zwischen Schalter (1) und Spule (2) materialeinheitlich ohne Verbindungsstelle ausgeführt ist.

5. Supraleitender Schalter (1) nach Anspruch 4, dadurch
gekennzeichnet, daß die Werte der Schichtdicke der Matrix
und/oder der Leitfähigkeit des Matrixmaterials im Bereich des
Supraleiters des Schalters (1) geringer sind, als die entsprechenden Werte des Supraleiters der Spule (2).

6. Supraleitender Schalter (1) nach einem der Anprüche 1
bis 5, dadurch gekennzeichnet, daß in der Nähe der Faserleiter des Schalters (1) wenigstens ein isolierter Heizdraht (10) angeordnet ist.

7. Supraleitender Schalter (1) nach einem der Ansprüche 1 bis 6, dadurch gekennzeichnet, daß in der Nähe der
Faserleiter des Schalters (1) ein zusätzlicher, ein Magnetfeld erzeugender Supraleiter angeordnet ist, in dessen
Magnetfeldbereich die Faserleiter des Schalter (1) verlaufen.

0074030